(19) Europäisches Patentamt
European Patent Office
Office européen des brevets

(11) **EP 4 478 428 A2**

(12) **EUROPEAN PATENT APPLICATION**

(43) Date of publication:
**18.12.2024 Bulletin 2024/51**

(21) Application number: **24210908.0**

(22) Date of filing: **05.11.2024**

(51) International Patent Classification (IPC):
**H01L 31/0352** (2006.01)  **H01L 31/0224** (2006.01)
**H01L 31/0216** (2014.01)

(52) Cooperative Patent Classification (CPC):
**H01L 31/035281; H01L 31/02167; H01L 31/022425**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **17.07.2024  CN 202410956630**

(71) Applicant: **Trina Solar Co., Ltd**
**Changzhou, Jiangsu 213031 (CN)**

(72) Inventors:
• **LIU, Chengfa**
**CHANGZHOU, 213031 (CN)**
• **LV, Dongyun**
**CHANGZHOU, 213031 (CN)**
• **ZHOU, Binbin**
**CHANGZHOU, 213031 (CN)**
• **LI, Zhenglin**
**CHANGZHOU, 213031 (CN)**
• **HUANG, Jian**
**CHANGZHOU, 213031 (CN)**

(74) Representative: **Arnold & Siedsma**
**Bezuidenhoutseweg 57**
**2594 AC The Hague (NL)**

(54) **SOLAR CELL, PREPARATION METHOD THEREOF, AND PHOTOVOLTAIC MODULE**

(57)     The present disclosure relates to a solar cell, a preparation method thereof, and a photovoltaic module. The solar cell includes a semiconductor substrate, passivating contact structures, a dielectric layer, and first electrodes. The semiconductor substrate includes a first surface and a second surface opposite to each other. The semiconductor substrate includes passivation regions and passivated contact regions, which are alternately arranged along a first direction. The first direction is perpendicular to a thickness direction of the semiconductor substrate. The passivating contact structures are disposed on the second surface and correspondingly disposed on the passivated contact regions. Each passivating contact structure includes an electrically conductive passivation layer. The dielectric layer at least covers the second surface in the passivation regions. The first electrodes are disposed on the passivating contact structures at a side away from the semiconductor substrate. Each passivating contact structure is provided with at least one first electrode.

FIG. 1

**Description**

TECHNICAL FIELD

The present application relates to the field of solar cell technology, particularly to solar cells, preparation methods thereof, and photovoltaic modules.

BACKGROUND

With the continuous development of solar cell technology, the demands for higher photoelectric conversion efficiencies of solar cells are increasing. However, the efficiency improvement in industrialized solar cells still faces many challenges. In particular, the contact recombination in the metal-silicon contact area, and the Auger recombination and deep-level recombination caused by diffusion in the silicon substrate are the main factors restricting the improvement of cell efficiency. Tunnel oxide passivated contact (TOPCon) cells reduce surface carrier recombination by including a passivating contact structure on the back side of the silicon substrate.

SUMMARY

In view of the above, there is a need to provide a solar cell, a preparation method thereof, and a photovoltaic module.

In a first aspect of the present application, a solar cell includes:

a semiconductor substrate, including a first surface and a second surface that are opposite to each other, wherein the semiconductor substrate includes a plurality of passivation regions and a plurality of passivated contact regions, the passivation regions and the passivated contact regions are alternately arranged along a first direction, the first direction is perpendicular to a thickness direction of the semiconductor substrate;
a plurality of passivating contact structures disposed on the second surface and correspondingly distributed on the passivated contact regions, wherein each passivating contact structure includes an electrically conductive passivation layer;
a dielectric layer, at least covering the second surface located in the passivation regions; and
a plurality of first electrodes disposed on the passivating contact structures and located at a side of the passivating contact structures away from the semiconductor substrate, wherein each passivating contact structure is provided with at least one first electrode.

In an embodiment, a first distance represents a distance between the second surface and the first surface in the passivation regions, and a second distance represents a distance between the second surface and the first surface in the passivated contact regions; the second distance is greater than the first distance.

In an embodiment, a difference between the second distance and the first distance is greater than 1 $\mu$m.

In an embodiment, the solar cell further includes a plurality of first diffusion layers located within the semiconductor substrate, the first diffusion layers are correspondingly located in the passivated contact regions, and each first diffusion layer is in contact with the second surface.

In an embodiment, the difference between the second distance and the first distance is greater than or equal to a size of each first diffusion layer in the thickness direction of the semiconductor substrate.

In an embodiment, the second surface is a back surface.

In an embodiment, a roughness of the second surface in the passivation regions is less than a roughness of the second surface in the passivated contact regions.

In an embodiment, a plurality of recesses are defined in the second surface, including a first recess and a second recess, the first recess is the deepest recess in the passivation regions, and the second recess is the deepest recess in the passivated contact regions; the first recess is shallower than the second recess.

In an embodiment, an inner size of the first recess is greater than an inner size of the second recess.

In an embodiment, a first distance represents a distance between the second surface and the first surface in the passivation regions, and a second distance represents a distance between the second surface and the first surface in the passivated contact regions; the second distance is greater than the first distance.

In an embodiment, along a direction from the second surface to the first surface, a dimension of the passivating contact structures in the first direction gradually decreases.

In an embodiment, the each passivating contact structure further includes a tunnel layer, and the tunnel layer is disposed between the electrically conductive passivation layer and the semiconductor substrate; along the direction from the second surface to the first surface, a dimension of the electrically conductive passivation layer in the first direction gradually decreases.

In an embodiment, the each passivating contact structure is provided with one first electrode; the electrically conductive passivation layer includes a first face adjacent to the tunnel layer and a second face away from the tunnel layer;

a dimension of the first face in the first direction, a dimension of the second face in the first direction, and a dimension of the first electrode in the first direction satisfy the following relationship:

$$W_2 > W_1 > W_3$$

wherein $W_1$ is the dimension of the first face in the first direction, $W_2$ is the dimension of the second face in the first direction, and $W_3$ is the dimension of the first electrode in the first direction.

In an embodiment, the dielectric layer further covers side surfaces of the passivating contact structures adjacent to the passivation regions.

In an embodiment, the second surface of the semiconductor substrate includes first sub-surfaces, second sub-surfaces, and connecting surfaces; the first sub-surfaces are located in the passivation regions, the second sub-surfaces are located in the passivated contact regions, and the first sub-surfaces and the second sub-surfaces are connected by the connecting surfaces adjacent thereto; the dielectric layer further covers the connecting surfaces.

In an embodiment, each second sub-surface includes a sub-contact surface and two non-contact surfaces, and the two non-contact surfaces are located at opposite sides of the sub-contact surface in the first direction; the passivating contact structure is in contact with the sub-contact surface; the dielectric layer further covers the two non-contact surfaces.

In an embodiment, a material of the dielectric layer includes one or more of aluminum oxide, silicon nitride, or silicon oxynitride.

In an embodiment, the electrically conductive passivation layer includes a doped polysilicon layer doped with an n-type doping element or a p-type doping element.

In an embodiment, the doped polysilicon layer is further doped with one or more of carbon, nitrogen, or oxygen.

In an embodiment, the electrically conductive passivation layer further includes a silicon carbide layer, and the silicon carbide layer is disposed at a side of the doped polysilicon layer away from the semiconductor substrate.

In a second aspect of the present application, a preparation method of a solar cell includes:

providing a semiconductor substrate, the semiconductor substrate including a first surface and a second surface that are opposite to each other, wherein the semiconductor substrate includes a plurality of passivation regions and a plurality of passivated contact regions, the passivation regions and the passivated contact regions are alternately arranged along a first direction, the first direction is perpendicular to a thickness direction of the semiconductor substrate;

forming a plurality of passivating contact structures on the second surface and correspondingly on the passivated contact regions, wherein each passivating contact structure includes an electrically conductive passivation layer;

forming a dielectric layer on the semiconductor substrate, the dielectric layer at least covering the second surface located in the passivation regions; and

forming a plurality of first electrodes on the plurality of passivating contact structures, at least one first electrode being formed at a side of each passivating contact structure away from the semiconductor substrate.

In an embodiment, forming the plurality of passivating contact structures includes:

forming a tunnel material layer and an electrically conductive passivation material layer that are stacked on the second surface;

forming a patterned mask layer on the electrically conductive passivation material layer;

removing the tunnel material layer and the electrically conductive passivation material layer on the passivation regions thereby forming the passivating contact structures.

In an embodiment, after forming the tunnel material layer and the electrically conductive passivation material layer stacked on the second surface, and prior to forming the patterned mask layer on the electrically conductive passivation material layer, the method further includes performing heat treatment on the electrically conductive passivation material layer thereby forming an initial diffusion layer; or

after forming the patterned mask layer on the electrically conductive passivation material layer, and prior to removing the tunnel material layer and the conductive passivation material layer on the passivation regions thereby forming the passivating contact structures, the method further includes performing heat treatment on the electrically conductive passivation material layer thereby forming an initial diffusion layer.

In an embodiment, after removing the tunnel material layer and the conductive passivation material layer on the passivation regions thereby forming the passivating contact structures, the method further includes removing the initial diffusion layer on the passivation regions thereby forming a plurality of first diffusion layers.

In a third aspect of the present application, a photovoltaic module includes the solar cell described in the first aspect.

In the solar cell, the preparation method thereof, and the photovoltaic module provided in the embodiments of the present application, the semiconductor substrate is divided into alternately arranged passivation regions and passivated contact regions, and the passivating contact structures on the second surface are located corresponding to the passivated contact regions. As such, the passivating contact structures on the second surface are spaced from each other, and compared with conventional TOPCon cells, can reduce the area of the second surface covered by the electrically conductive passivation layer, thereby reducing the amount of long-wavelength light absorbed by the electrically conductive passivation layer, increasing the electric currents, and improving the solar cell efficiency.

BRIEF DESCRIPTION OF THE DRAWINGS

In order to illustrate the embodiments and examples of the present application more clearly, the drawings used in the embodiments and examples will be described briefly. Apparently, the following described drawings are merely for the embodiments of the present application, and other drawings can be derived by those of ordinary skill in the art without any creative effort.

FIG. 1 is a schematic cross-sectional partial view of a solar cell according to an embodiment of the present application.
FIG. 2 is a schematic partial view of a semiconductor substrate of the solar cell shown in FIG. 1.
FIG. 3 is an enlarged view of part A in FIG. 2.
FIG. 4 is an enlarged view of part B in FIG. 2.
FIG. 5 is a schematic view of a semiconductor substrate and a passivating contact structure of the solar cell shown in FIG. 1.
FIG. 6 shows a flow chart of a method for preparing a solar cell according to an embodiment of the present application.
FIG. 7 shows a flow chart of an embodiment of S20 in the method shown in FIG. 6.
FIG. 8 shows a flow chart of another embodiment of S20 in the method shown in FIG. 6.
FIG. 9 is a schematic cross-sectional partial view of an embodiment of a semiconductor substrate after a texturing process in the method shown in FIG. 6.
FIG. 10 is a schematic cross-sectional partial view of an embodiment of a semiconductor substrate after a polishing process in the method shown in FIG. 6.
FIG. 11 is a schematic cross-sectional partial view of an embodiment of an unfinished solar cell structure formed after processes of forming a tunnel material layer, an electrically conductive passivation material layer, and an oxide layer on a semiconductor substrate in the method shown in FIG. 6.
FIG. 12 is a schematic cross-sectional partial view of an embodiment of an unfinished solar cell structure formed after a heat treatment process in the method shown in FIG. 6.
FIG. 13 is a schematic cross-sectional partial view of an embodiment of an unfinished solar cell structure formed after a process of forming a patterned mask layer in the method shown in FIG. 6.
FIG. 14 is a schematic cross-sectional partial view of an embodiment of an unfinished solar cell structure formed after a process of forming a passivating contact structure in the method shown in FIG. 6.
FIG. 15 is a schematic cross-sectional partial view of an embodiment of an unfinished solar cell structure formed after a process of forming a dielectric layer in the method shown in FIG. 6.

Reference signs in the drawings:

1 - solar cell; 11 - semiconductor substrate; 11a - passivation region; 11b - passivated contact region; 111 - first surface; 112 - second surface; 1121 - first sub-surface; 1122 - second sub-surface; 11221 - sub-contact surface; 11222 - non-contact surface; 1123 - connecting surface; 12 - passivating contact structure; 121 - tunnel layer; 122 - electrically conductive passivation layer; 13 - dielectric layer; 14 - first electrode; 15 - first diffusion layer; 16 - recess; 16a - first recess; 16b - second recess; 21 - tunnel material layer; 22 - electrically conductive passivation material layer; 231 - oxide layer; 232 - patterned mask layer; 24 - initial diffusion layer.

DETAILED DESCRIPTION

To make the objectives, features, and advantages of the present application more understandable, detailed description of specific embodiments are provided below with reference to the accompanying drawings. Many specific details are disclosed in the following description to facilitate a comprehensive understanding of the present application. However, it should be noted that the present application can be implemented in various ways different from those described herein, and those skilled in the art may make similar improvements without departing from the scope of the present application. Therefore, the present application is not limited to the specific embodiments disclosed below.

Unless defined otherwise, all technical and scientific terms used herein have the same meaning as commonly understood by those skilled in the art of the present application. The terms used in the specification of the present application are for the purpose of describing exemplary embodiments only and are not intended to limit the present application.

It should be understood that when an element or layer is referred to as being "on", "adjacent to", "connected to", or "coupled to" another element or layer, it can be directly on, adjacent to, connected to, or coupled to the other element or layer, or an intermediate element or layer can be present. In contrast, when an element is referred to as being "directly on", "directly adjacent to", "directly connected to", or "directly coupled to" another element or layer, there is no intervening element or layer. It can be understood that although the terms first, second, third etc. may be used to describe various elements, components, regions, layers, doping types and/or sections, these elements, components, regions, layers, doping types and/or sections should not be limited by these terms. These terms are only used to distinguish one element, component, region, layer, doping type or section from another element, component, region, layer, doping type or section. Thus, a first element, component, region, layer, doping type or section described below can be termed as a second element, component, region, layer, doping type or section without departing from the teachings of the present application.

For the convenience of description, the spatial relation terms such as "below", "under", "beneath", "above", "on", "over", etc., may be used herein to describe the relationships of an element or a feature with other elements or features shown in the drawings. It should be understood that the terms of spatial relations are intended to include other different orientations in use or operation in addition to the orientation of the elements or features shown in the drawings. For example, if the drawings are placed upside down, the element or feature which was "above" or "over" other elements or features will be "below" or "under" other elements or features. Thus, the exemplary terms "below" and "beneath" may cover the meanings of "above" or "below". The element or feature can also be positioned in other different ways (e.g., rotating 90 degrees or at other orientations), and the spatial relation terms used herein can be correspondingly interpreted.

The terminology used herein is for the purpose of describing particular embodiments only and is not intended to limit the present application. As used herein, the singular forms with "a", "an", "the", or "said" are intended to include the plural forms as well, unless the context clearly indicates otherwise. It should also be understood that the terms "consists of" and "comprising", when used in the present application, identify the presence of the stated features, integers, steps, operations, elements and/or parts, but do not exclude presence or addition of one or more other features, integers, steps, operations, elements, parts and/or groups. As used herein, the term "and/or" means that any one of the listed items can be employed by itself or any combination of two or more of the listed items can be employed.

The embodiments of the present application are described herein with reference to drawings showing cross-sectional views of idealized embodiments (and intermediate structures) of the present application, which are schematic views. It can be expected that some variations of the shown shapes may exist due to, for example, manufacturing techniques and/or engineering tolerances. Thus, embodiments of the present application should not be limited to the particular shapes of the regions shown herein but include deviations in shapes due to, for example, manufacturing. Thus, the regions shown in the drawings are schematic in nature, and their shapes are not intended to be the actual shapes of the regions of the device or limit the scope of the present application.

As described in the background, conventional TOPCon cells include a continuous passivating contact structure disposed on the back side of the silicon substrate to reduce the surface carrier recombination. However, the doped polysilicon layer of the passivating contact structure prominently absorbs long-wavelength light, causing phenomenon of parasitic absorption, which reduces the generated electric currents and affects the solar cell efficiency.

In a related technique, the doped polysilicon layer is thinned to reduce the absorption of long-wavelength light by the doped polysilicon layer. However, during the formation of metal electrodes, the metal paste may easily burn through the passivating contact structure, affecting the passivation effect.

In another related technique, the doped polysilicon layer has selective thicknesses, is thicker in the regions with metal electrodes and thinner in the regions without metal electrodes. However, this structure still has a parasitic absorption to some extent, and the preparation process of this structure is complex and may be not suitable for mass production.

In view of at least one of the above issues, embodiments of the present application provide a solar cell, a preparation method thereof, and a photovoltaic module, in which a semiconductor substrate is divided into alternately arranged passivation regions and passivated contact regions, and passivating contact structures on a second surface of the semiconductor substrate are located corresponding to the passivated contact regions. As such, the passivating contact structures on the second surface are spaced from each other. Compared with conventional TOPCon cells, this structure can reduce the area of the second surface covered by the passivating contact structures, thereby reducing the amount of long-wavelength light absorbed by the passivating contact structures, increasing the electric currents, and improving the cell efficiency. Additionally, compared with the first related technique, the solar cell provided by the present application does not affect the passivation effect; compared with the second related technique, the solar cell provided by the present application is easier to prepare and more suitable for mass production.

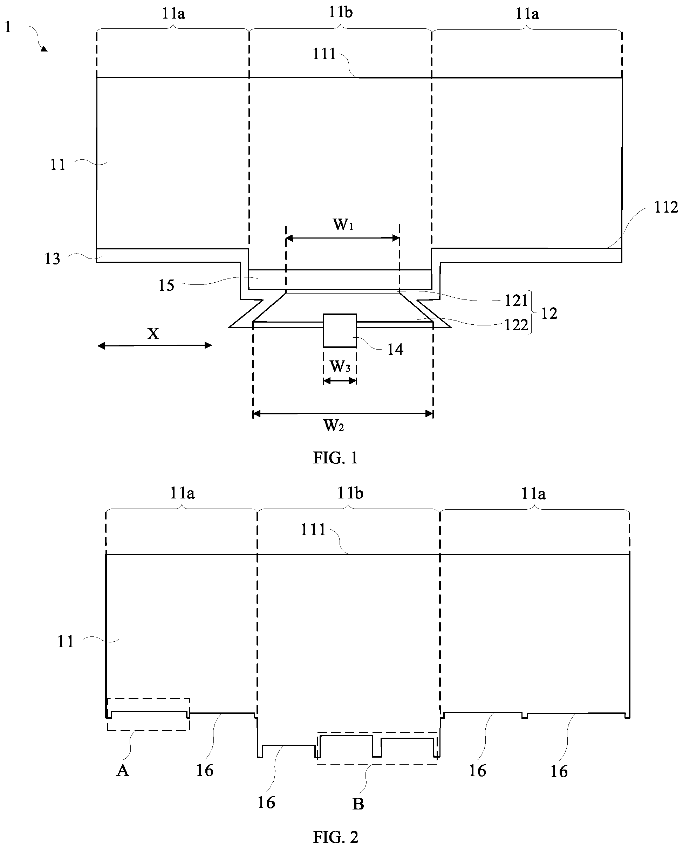

In a first aspect, referring to FIG. 1, an embodiment of the present application provides a solar cell 1, which can be a TOPCon cell. Specifically, the solar cell 1 includes a semiconductor substrate 11, a plurality of passivating contact structures 12, a dielectric layer 13, and a plurality of first electrodes 14.

The semiconductor substrate 11 can be made of silicon. The semiconductor substrate 11 includes a first surface 111 and a second surface 112, which are opposite to each other. Specifically, in the first surface 111 and the second surface 112, one can be the light-facing surface, and the other can be the back surface. The semiconductor substrate 11 includes a plurality of passivation regions 11a and a plurality of passivated contact regions 11b, which are alternately arranged along a first direction X. The first direction X is perpendicular to the thickness direction of the semiconductor substrate 11. The passivating contact structures 12 are disposed on the second surface 112 and are correspondingly disposed on the passivated contact regions 11b. Each passivating contact structure 12 includes an electrically conductive passivation layer 122. The first electrodes 14 are disposed on the passivating contact structures 12 and located at a side of the passivating contact structures 12 away from the semiconductor substrate 11, and each passivating contact structure 12 is provided with at least one first electrode 14. The dielectric layer 13 at least covers the second surface 112 located in the passivation regions 11a.

In some embodiments, the alternating arrangement of the passivation regions 11a and the passivated contact regions 11b is between two passivation regions 11a and two passivated contact regions 11b. In other words, a plurality of groups each including two passivation regions 11a and a plurality of groups each including two passivated contact regions 11b are alternately arranged. In some other embodiments, the alternating arrangement of the passivation regions 11a and the passivated contact regions 11b is between an individual passivation region 11a and an individual passivated contact region 11b. In other words, one passivation region 11a is located between any two adjacent passivated contact regions 11b, and one passivated contact regions 11b is disposed between any two adjacent passivation regions 11a.

The passivating contact structures 12 can be in one-to-one correspondence with the passivated contact regions 11b. Alternatively, two, three, or more passivating contact structures 12 can be correspondingly disposed on one passivated contact region 11b. Each passivating contact structure 12 can be provided with one, two, or more first electrodes 14. It should be noted that since only one passivated contact region 11b is shown in FIG. 1, only one first diffusion layer 15 is shown in FIG. 1.

In the solar cell 1, the passivating contact structures 12 are spaced from each other on the second surface 112. Compared with conventional TOPCon cells, no passivating contact structures 12 are disposed on the second surface 112 in the passivation regions 11a, thereby reducing the area of the second surface 112 covered by the passivating contact structures 12 (such as the electrically conductive passivation layer 122). This coverage area reduction decreases the absorption of long-wavelength light by the passivating contact structures 12 (such as the electrically conductive passivation layer 122), thereby increasing the electric currents and enhancing solar cell efficiency.

Moreover, compared with the first related technique, the passivating contact structures 12 in the solar cell 1 of the present embodiment are not thinned, and thus during the formation of the metal electrodes, the metal paste is less likely to burn through the passivating contact structures 12, so as not to adversely affect the passivation effect. Compared with the second related technique, in the preparation process of the solar cell 1 of the present embodiment, all the materials of the passivating contact structures 12 in the passivation regions 11a are removed, which provides a larger process window and reduces preparation difficulty, making mass production more feasible.

In some embodiments, the solar cell 1 further includes a plurality of first diffusion layers 15 located within the semiconductor substrate 11. The first diffusion layers 15 are correspondingly located in the passivated contact regions 11b, and each first diffusion layer 15 is in contact with the second surface 112. In other words, the first diffusion layers 15 are surface regions of the passivated contact regions 11b directly adjacent to the second surface 112.

In some embodiments, no diffusion layers are provided within the passivation regions 11a of the semiconductor substrate 11 and adjacent to the second surface 112, which is conducive to reducing carrier recombination. The first diffusion layers 15 are located within the passivated contact regions 11b of the semiconductor substrate 11 and adjacent to the second surface 112, which is conducive to enhancing carrier collection efficiency.

In an embodiment, the first surface 111 is the light-receiving surface, and the second surface 112 is the back surface. Thus, the passivating contact structures 12 are spaced and disposed on the back surface. Compared to conventional TOPCon cells, no passivating contact structures are disposed on the second surface 112 in the passivation regions 11a, thereby reducing the area of the second surface 112 covered by the passivating contact structures 12 (such as the electrically conductive passivation layer 122), and thus reducing the amount of long-wavelength light absorbed by the passivating contact structures 12 (such as the electrically conductive passivation layer 122), increasing the electric currents, and improving the cell efficiency.

In an embodiment, a first distance represents a distance between the second surface 112 and the first surface 111 in the passivation regions 11a, and a second distance represents a distance between the second surface 112 and the first surface 111 in the passivated contact region 11b. The second distance is greater than the first distance. In some embodiments, the depth of the second surface 112 in the passivation regions 11a is greater than the depth of the second surface 112 in the passivated contact regions 11b, and the depth of the second surface 112 in the passivated contact regions 11b can be set as zero.

The above described difference between the first and second distances provides following effects: It facilitates the formation of spaced passivating contact structures 12 on the second surface 112. In addition, it can be created by removing the diffusion layers from the passivation regions 11a, and the removal of the diffusion layers from the passivation regions 11a is conductive to reducing carrier recombination. Furthermore, during the manufacturing process, recesses 16 are formed in the second surface 112 of the semiconductor substrate 11. By configuring the depth of the second surface 112 in the passivation regions 11a to be greater than the depth of the second surface 112 in the passivated contact regions 11b, the second surface 112 in the passivation regions 11a can be etched deeper, which is conducive to forming shallower recesses 16 with larger inner sizes in the passivation regions 11a, resulting in a smoother second surface 112 in the passivation regions 11a with increased light reflections.

In some embodiments, the difference between the second distance and the first distance is greater than 1 $\mu$m. As such, the diffusion layers in the passivation regions 11a can be completely removed, thereby reducing the carrier recombination. Additionally, during the manufacturing process, the second surface 112 in the passivation regions 11a can be etched deeper, forming shallower recesses 16 with larger inner sizes, and thus forming a smoother second surface 112 in the passivation regions 11a with increased light reflections.

In some embodiments, referring to FIG. 1, the difference between the second distance and the first distance is greater than or equal to the size of each first diffusion layer 15 along the thickness direction of the semiconductor substrate 11. The difference between the second distance and the first distance is the depth of the second surface 112 in the passivation regions 11a relative to the second surface 112 in the passivated contact regions 11b. The size of each first diffusion layer 15 along the thickness direction of the semiconductor substrate 11 is the thickness of the first diffusion layer 15.

By configuring the depth of the second surface 112 in the passivation regions 11a to be greater than or equal to the thickness of the first diffusion layer 15, the first diffusion layers 15 in the passivation regions 11a can be completely removed, which is conducive to reducing the carrier recombination. In addition, the roughness of the second surface 112 in the passivation regions 11a can be reduced, thereby increasing the light reflections and enhancing the passivation effect.

In some embodiments, the second surface 112 in the passivation regions 11a can have a non-pyramidal microstructure morphology, while the second surface 112 in the passivated contact regions 11b can have a pyramidal microstructure morphology.

In some embodiments, the roughness of the second surface 112 in the passivation regions 11a is less than that of the second surface 112 in the passivated contact regions 11b. Here, the roughness refers to surface roughness.

As such, the smoothness of the second surface 112 in the passivation regions 11a can be increased, thereby enhancing the mirror reflection effect. When light enters at a fixed angle, the smoother second surface 112 in the passivation regions 11a provides better light reflection, and thus more long-wavelength light can be reflected back into the semiconductor substrate 11, which improves the electric currents and enhances the cell efficiency.

In some embodiments, the reflectivity of the second surface 112 in the passivation regions 11a is greater than that of the second surface 112 in the passivated contact regions 11b. This is partly because the roughness of the second surface 112 in the passivation regions 11a is less than that of the second surface 112 in the passivated contact regions 11b, and partly because the second surface 112 in the passivation regions 11a is not covered by any passivating contact structures 12, resulting in lower absorption of long-wavelength light.

In some embodiments, as shown in FIGs. 2, 3, and 4, a plurality of recesses 16 are defined in the second surface 112, including recesses 16 in the passivation regions 11a and recesses 16 in the passivated contact regions 11b. It should be noted that FIGs 2 to 4 shows microscopic schematic view of the second surface 112 of the semiconductor substrate 11, while FIGs. 1, 5, and 11 to 15 are more macroscopic and do not show the recesses for simplicity.

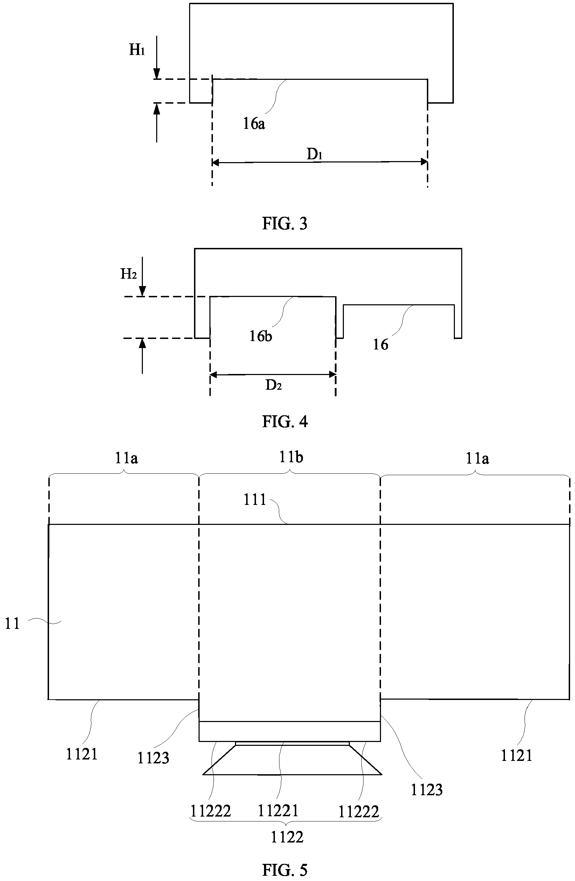

The deepest recess 16 in the passivation regions 11a is referred to as a first recess 16a, and the deepest recess 16 in the passivated contact regions 11b is referred to as a second recess 16b. The depth of the first recess 16a is less than that of the second recess 16b. Here, the dimension of the first recess 16a along the thickness direction of the semiconductor substrate 11 is the depth of the first recess 16a, and the dimension of the second recess 16b along the thickness direction of the semiconductor substrate 11 is the depth of the second recess 16b. Referring to FIGs. 3 and 4, the dimension of the first recess 16a along the thickness direction of the semiconductor substrate 11 is $H_1$, and

the dimension of the second recess 16b along the thickness direction of the semiconductor substrate 11 is $H_2$.

It should be noted that the recesses are formed as a result of polishing the surface of the semiconductor substrate 11. In order to remove the diffusion layers in the passivation regions 11a, the second surface 112 is further polished in the passivation regions 11a. During the further polishing process, the depth of the recesses 16 in the passivation regions 11a is reduced. Thus, the depths of most recesses 16 in the passivation regions 11a are reduced. Furthermore, the depths of the recesses 16 affect the roughness. In the same surface, the smaller the depth difference between the deepest recess 16 and the shallowest recess 16, the smaller the roughness of this surface. Therefore, the first recess 16a being shallower than the second recess 16b is conductive to making the roughness of the second surface 112 in the passivation regions 11a less than that of the second surface 112 in the passivated contact regions 11b.

In some embodiments, the roughness of the second surface 112 in the passivation regions 11a can be reflected by the depths of all recesses 16 in the passivation regions 11a. Furthermore, the standard deviation of the depths of all recesses 16 in the passivation regions 11a is the roughness of the second surface 112 in the passivation regions 11a.

The roughness of the second surface 112 in the passivated contact regions 11b can be reflected by the depths of all recesses 16 in the passivated contact regions 11b. Furthermore, the standard deviation of the depths of all recesses 16 in the passivated contact regions 11b is the roughness of the second surface 112 in the passivated contact regions 11b.

The standard deviation of the depths of all recesses 16 in the passivation regions 11a is less than the standard deviation of the depths of all recesses 16 in the passivated contact regions 11b.

It should be noted that the standard deviation of the depths of all recesses 16 can be represented by the standard deviation of the depths of all recesses 16 per unit area.

In some embodiments, the inner size of the first recess 16a is greater than the inner size of the second recess 16b. Referring to FIG. 3, the inner size of the first recess 16a is $D_1$, and referring to FIG. 4, the inner size of the second recess 16b is $D_2$. It should be noted that the inner size of the recess 16 refers to the size of a cross section of the recess 16 along the direction perpendicular to the thickness direction of the semiconductor substrate 11. When the recess 16 is a round recess, the inner size of the recess 16 is the inner diameter of the round recess. When the recess 16 is a square recess, the inner size of the recess 16 is the side length of the square recess. When the recess 16 is a rectangular recess, the inner size of the recess 16 is the longest side length of the rectangular recess. When the recess 16 is an irregularly shaped recess, the inner size of the recess 16 is the maximum inner size of the irregular shaped recess.

It can be understood that the inner size of the recess 16 is inversely proportional to the depth of the recess 16. During the polishing process to remove the diffusion layers in the passivation regions 11a, the depths of the recesses 16 in the passivation regions 11a are reduced, and the inner sizes of the recesses 16 are increased. Thus, the inner size of the first recess 16a is greater than the inner size of the second recess 16b.

In some embodiments, the inner size of each recess 16 in the passivation regions 11a is greater than the inner size of the largest recess 16 (e.g., the second recess 16b) in the passivated contact regions 11b. As such, the depth of each recess 16 in the passivation regions 11a is less than the depth of the deepest recess 16 (e.g., the second recess 16b) in the passivated contact regions 11b. As a result, the roughness of the second surface 112 in the passivation regions 11a is less than the roughness of the second surface 112 in the passivated contact regions 11b.

In alternative embodiments, the inner sizes of only a portion of the recesses 16 in the passivation region 11a are each greater than the inner size of the largest recess 16 (e.g., the second recess 16b) in the passivated contact regions 11b. As such, the depths of only a portion of the recesses 16 in the passivation regions 11a are each less than the depth of the deepest recess 16 (e.g., the second recess 16b) in the passivated contact regions 11b.

In some embodiments, the inner size of the first recess 16a ranges from 8 $\mu$m to 40 $\mu$m. For example, the inner size of the first recess 16a can be 8 $\mu$m, 15 $\mu$m, 23 $\mu$m, 30 $\mu$m, 35 $\mu$m, 40 $\mu$m, or any value between these numbers.

In some embodiments, the inner size of the second recess 16b ranges from 5 $\mu$m to 20 $\mu$m. For example, the inner size of the second recess 16b can be 5 $\mu$m, 10 $\mu$m, 15 $\mu$m, 20 $\mu$m, or any value between these numbers.

In some embodiments, the depth of the first recess 16a ranges from 50 nm to 800 nm. For example, the depth of the first recess 16a can be 50 nm, 200 nm, 400 nm, 600 nm, 800 nm, or any value between these numbers.

In some embodiments, the depth of the second recess 16b ranges from 200 nm to 1000 nm. For example, the depth of the second recess 16b can be 200 nm, 400 nm, 500 nm, 700 nm, 850 nm, 1000 nm, or any value between these numbers.

By having the dimensions (such as depth and inner size) of the first recess 16a and the second recess 16b fall within the above ranges, the recesses 16 of different dimensions can be formed in the second surface 112 and respectively in the passivation regions 11a and the passivated contact regions 11b, which is conducive to making the roughness of the second surface 112 in the passivation regions 11a less than the roughness of the second surface 112 in the passivated contact regions 11b.

In some embodiments, referring to FIG. 1, along the direction from the second surface 112 to the first surface 111, the dimension of the passivating contact structure 12 in the first direction X gradually decreases. In other words, along the direction from the second surface 112 to the first surface 111, the width of the passivating contact structure 12 gradually decreases. Under the condition of having the same length, the passivating contact structure 12 has a larger surface at the side away from the semiconductor substrate 11 and a smaller surface at the side adjacent to the semiconductor substrate 11. As such, on the one hand, the first electrode 14 can be easily in alignment with the passivating contact structure 12 during the manufacturing process, and on the other hand, the contact area between the passivating contact structure 12 and the semiconductor substrate 11 can be reduced, thereby reducing the absorption of long-wavelength light by the passivating contact structure 12.

In some embodiments, the passivating contact structure 12 further includes a tunnel layer 121. The tunnel layer 121 is disposed between the electrically conductive passivation layer 122 and the semiconductor substrate 11. Along the direction from the second surface 112 to the first surface 111, the dimension of the electrically conductive passivation layer 122 in the first direction X gradually decreases, in other words, the width of the electrically conductive passivation layer 122 gradually decreases. The tunnel layer 121 can be made of silicon oxide. The electrically conductive passivation layer 122 can be made of polysilicon, microcrystalline silicon, or silicon carbide, doped with an n-type doping element or a p-type doping element.

The inventors found through research that the electrically conductive passivation layer 122 (e.g., a polysilicon layer) is prone to absorbing long-wavelength light. The above arrangement makes the surface area of the electrically conductive passivation layer 122 at the side adjacent to the semiconductor substrate 11 smaller, which is beneficial to reducing the absorption of long-wavelength light by the electrically conductive passivation layer 122, and makes the surface area of the electrically conductive passivation layer 122 at the side away from the semiconductor substrate 11 larger, which facilitates alignment with the first electrode 14 during the manufacturing process, reducing the manufacturing difficulty of the first electrode 14.

In some embodiments, the each passivating contact structure 12 is provided with one first electrode 14. The electrically conductive passivation layer 122 includes a first face adjacent to the tunnel layer 121 and a second face away from the tunnel layer 121. The dimension of the first face in the first direction X, the dimension of the second face in the first direction X, and the dimension of the first electrode 14 in the first direction X satisfy the following relationship:

$$W_2 > W_1 > W_3$$

wherein $W_1$ is the dimension of the first face in the first direction X, $W_2$ is the dimension of the second face in the first direction X, and $W_3$ is the dimension of the first electrode 14 in the first direction X.

The above arrangement makes the surface area of the electrically conductive passivation layer 122 at the side adjacent to the semiconductor substrate 11 smaller, which is beneficial to reducing the absorption of long-wavelength light by the electrically conductive passivation layer 122, and makes the surface area of the electrically conductive passivation layer 122 at the side away from the semiconductor substrate 11 larger, which facilitates alignment with the first electrode 14 during the manufacturing process, reducing the manufacturing difficulty of the first electrode 14.

In some embodiments, the thickness of the tunnel layer 121 ranges from 0.5 nm to 2 nm. For example, the thickness of the tunnel layer 121 can be 0.5 nm, 1 nm, 1.5 nm, or 2 nm.

In some embodiments, the solar cell 1 further includes the dielectric layer 13; the dielectric layer 13 at least covers the second surface 112 in the passivation regions 11a, and also covers the surfaces of the passivated contact structures 12 away from the semiconductor substrate 11.

In some embodiments, the dielectric layer 13 is in direct contact with the second surface 112 in the passivation regions 11a. Since the roughness of the second surface 112 in the passivation regions 11a is smaller, i.e., the smoothness is better, the passivation effect of the dielectric layer 13 is improved. Additionally, covering the surfaces of the passivated contact structures 12 away from the semiconductor substrate 11 with the dielectric layer 13 enhances the passivation effect of the passivated contact structures 12.

In some embodiments, the thickness of the dielectric layer 13 is less than 30 nm. For example, the thickness of the dielectric layer 13 can be 25 nm, 20 nm, or 10 nm.

In some embodiments, the dielectric layer 13 further covers the surfaces of the passivated contact structures 12 adjacent to the passivation regions 11a, i.e., the side surfaces of the passivated contact structures 12. This arrangement further enhances the passivation effect of the passivated contact structures 12.

In some embodiments, referring to FIG. 5, the second surface 112 of the semiconductor substrate 11 includes first sub-surfaces 1121, second sub-surfaces 1122, and connecting surfaces 1123. The first sub-surfaces 1121 are respectively located in the passivation regions 11a. The second sub-surfaces 1122 are respectively located in the passivation contact regions 11b. The connecting surfaces 1123 connect the adjacent first sub-surfaces 1121 and second sub-surfaces 1122. The dielectric layer 13 further covers the connecting surfaces 1123. As shown in FIG. 5, the second sub-surface 1122 and the connecting surface 1123 together form a step. Covering the connecting surfaces 1123 with the dielectric layer 13 can provide a good passivation effect at the side surfaces of the steps.

In some embodiments, the second sub-surface 1122 includes a sub-contact surface 11221 and two non-contact surfaces 11222. The two non-contact surfaces 11222 are located at opposite sides of the sub-contact surface 11221 in the first direction X. The passivated contact structure 12 is in contact with the sub-contact surface 11221. The dielectric layer 13 further covers the non-contact surfaces 11222. As such, the non-contact surfaces 11222 of the second sub-surface 1122 can have a good passivation effect.

In some embodiments, referring to FIG. 1, a fitting groove can be formed between the passivated contact structure 12 and the non-contact surface 11222, and the dielectric layer 13 can be embedded in the fitting groove. As such, the bonding strength between the dielectric layer 13 and the semiconductor substrate 11 can be enhanced, improving the structural stability of the solar cell 1.

In some embodiments, the dielectric layer 13 includes one or more of aluminum oxide, silicon nitride, or silicon oxynitride.

In an embodiment, the dielectric layer 13 includes an aluminum oxide layer, which at least covers the second surface 112 located in the passivation regions 11a. In the related art, the second surface 112 in the passivation regions 11a may be covered with the electrically conductive passivation layer 122 (such as a doped polysilicon layer). The aluminum oxide layer can provide a good passivation effect in the passivation regions 11a, which is comparable to that of a doped polysilicon layer.

In another embodiment, the dielectric layer 13 includes a silicon nitride layer, which at least covers the second surface 112 located in the passivation regions 11a. The silicon nitride layer thus provides a good passivation effect in the passivation regions 11a, thereby enhancing the performance of the solar cell 1.

It can be understood that the dielectric layer 13 can be a laminated structure including at least two layers selected from an aluminum oxide layer, a silicon nitride layer, and a silicon oxynitride layer. The specific structure of the dielectric layer 13 is not limited in the present application.

In some embodiments, the electrically conductive passivation layer 122 includes a doped polysilicon layer, which is doped with an n-type doping element or a p-type doping element. As such, the passivated contact structure 12 can have a relatively good electrical conductivity.

In some embodiments, the doped polysilicon layer is further doped with one or more of carbon, nitrogen, and oxygen, which increases the bandgap of the layer, further reduces light absorption, and thereby improves the efficiency of the solar cell 1.

It can be understood that the electrically conductive passivation layer 122 can consist solely of a doped polysilicon layer.

In some embodiments, the electrically conductive passivation layer 122 further includes a doped microcrystalline silicon layer, which is doped with an n-type doping element or a p-type doping element.

In some embodiments, the electrically conductive passivation layer 122 further includes a silicon carbide layer, which is disposed at the side of the doped polysilicon layer away from the semiconductor substrate 11. It can be understood that the silicon carbide layer can also be doped with an n-type doping element or a p-type doping element.

By providing the silicon carbide layer, light absorption by the electrically conductive passivation layer 122 can be reduced, which is beneficial for improving the efficiency of the solar cell 1. Additionally, during the fabrication of the first electrodes 14, the silicon carbide layer can withstand metal burning, which is conducive to reducing carrier recombination at the metal electrodes. It should be noted that during the manufacturing process, the first electrode 14 burns through the dielectric layer 13 and thus is in contact with the electrically conductive passivation layer 122, e.g., in contact with at least one of the silicon carbide layer and the doped polysilicon layer.

In some embodiments, the material of the tunnel layer 121 includes at least one of silicon oxide, silicon nitride, intrinsic amorphous silicon, intrinsic polysilicon, aluminum oxide, aluminum nitride, phosphorus nitride, or titanium nitride.

In some embodiments, the material of the electrically conductive passivation layer 122 includes at least one of polysilicon, microcrystalline silicon, or silicon carbide. Further, the electrically conductive passivation layer 122 is doped with an n-type doping element or a p-type doping element.

In some embodiments, the solar cell 1 further includes an emitter, one or more second electrodes, and a passivation layer. The emitter and the passivation layer are sequentially stacked on the first surface 111 of the semiconductor substrate 11, and the second electrodes penetrate through the passivation layer to electrically connect with the emitter.

In some embodiments, the first electrodes 14 are made of at least one of silver or aluminum. In an embodiment, the first electrode 14 includes both silver and aluminum. The first electrode 14 can be made from a silver-aluminum paste.

In some embodiments, the second electrodes are made of at least one of silver and aluminum. In an embodiment, the second electrode includes both silver and aluminum. The second electrode can be made from a silver-aluminum paste.

The conventional TOPCon cells and the solar cells provided in the embodiments of the present application were tested. The test results are shown in Table 1.

Table 1: Comparison of Solar Cell Performance

| | Efficiency (%) | Short-circuit current $I_{sc}$ (mA/cm$^2$) | Open-circuit voltage $V_{oc}$ (mV) | Fill factor FF (%) |
|---|---|---|---|---|
| Conventional TOPCon cells | 24.95 | 41.02 | 730.1 | 83.31 |
| Present embodiments | 25.08 | 41.21 | 730.7 | 83.29 |

It can be seen from the above table that the short-circuit currents of the solar cells provided in the embodiments of the present application can be increased by 0.19 mA/cm$^2$ and the cell efficiency can be increased by 0.13%.

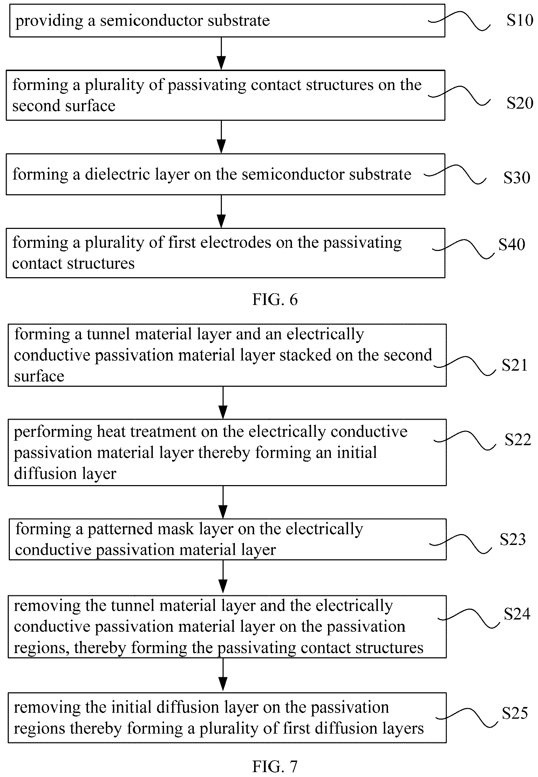

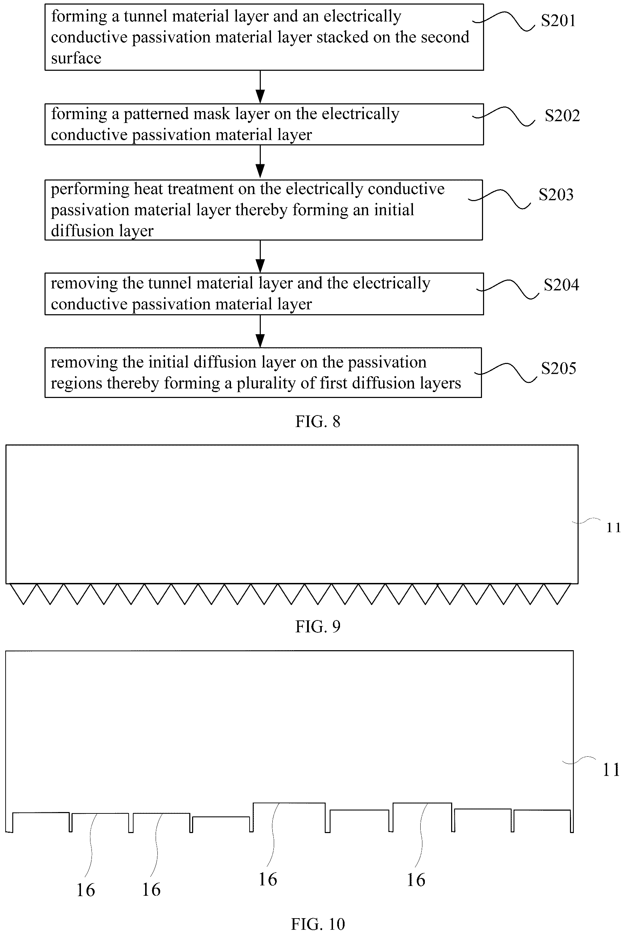

In a second aspect, referring to the flow charts shown in FIGs. 6 to 8, in combination with the structural view shown in FIGs. 9 to 15, an embodiment of the present application provides a method for preparing a solar cell, which can be the solar cell 1 described in the first aspect. The method includes steps S10 to S40.

S10: providing a semiconductor substrate 11. The semiconductor substrate 11 includes a first surface 111 and a second surface 112 that are opposite to each other. The semiconductor substrate 11 includes a plurality of passivation regions 11a and a plurality of passivated contact regions 11b. The passivation regions 11a and the passivated contact regions 11b are alternately arranged along a first direction X. The first direction X is perpendicular to a thickness direction of the semiconductor substrate 11. The semiconductor substrate 11 can be an n-type silicon substrate. In the present step, referring to FIG. 9, the semiconductor substrate 11 can be textured first. After texturizing, referring to FIG. 10, the second surface 112 of the semiconductor substrate 11 can be polished using an alkaline solution. After polishing, the second surface 112 of the semiconductor substrate 11 is formed to include a plurality of recesses 16.

S20: forming a plurality of passivating contact structures 12 on the second surface 112. The passivating contact structures 12 are correspondingly disposed on the passivated contact regions 11b. Each passivating contact structure 12 includes an electrically conductive passivation layer 122.

S30: forming a dielectric layer 13 on the semiconductor substrate 11. The dielectric layer 13 at least covering the second surface 112 located in the passivation regions 11a. The material of the dielectric layer 13 can include one or more of silicon oxide, aluminum oxide, silicon oxynitride, or silicon nitride. In some embodiments, the dielectric layer 13 can be formed by an atomic layer deposition (ALD) method. This method allows the dielectric layer 13 to be embedded in the fitting groove formed between the passivation contact structure 12 and the non-contact surface 11222.

S40: forming a plurality of first electrodes 14 on the passivating contact structures 12 at a side of the passivating contact structures 14 away from the semiconductor substrate 11. At least one first electrode 14 is formed on each passivating contact structure 12.

In the preparation method of the solar cell provided in the embodiments of the present application, the passivating contact structures 12 are formed on the second surface 112 and spaced from each other. Compared with conventional TOPCon cells, no passivating contact structures 12 are formed on the second surface 112 in the passivation regions 11a, thereby reducing the area of the second surface 112 covered by the passivating contact structures 12, decreasing the absorption of long-wavelength light by the passivating contact structures 12, thereby increasing the electric currents and enhancing solar cell efficiency.

Moreover, compared with the first related technique, in the preparation method of the solar cell 1 of the present embodiments, the passivating contact structures 12 are not thinned, and thus during the formation of the metal electrodes, the metal paste is less likely to burn through the passivating contact structures 12, so as not to adversely affect the passivation effect. Compared with the second related technique, in the preparation method of the solar cell 1 of the present embodiments, all the materials of the passivating contact structures 12 in the passivation regions 11a are removed, which provides a larger process window and reduces preparation difficulty, making mass production more feasible.

In some embodiments, referring to FIG. 7, S20 of forming the plurality of passivating contact structures 12 on the second surface 112 specifically includes steps S21, S23, and S24.

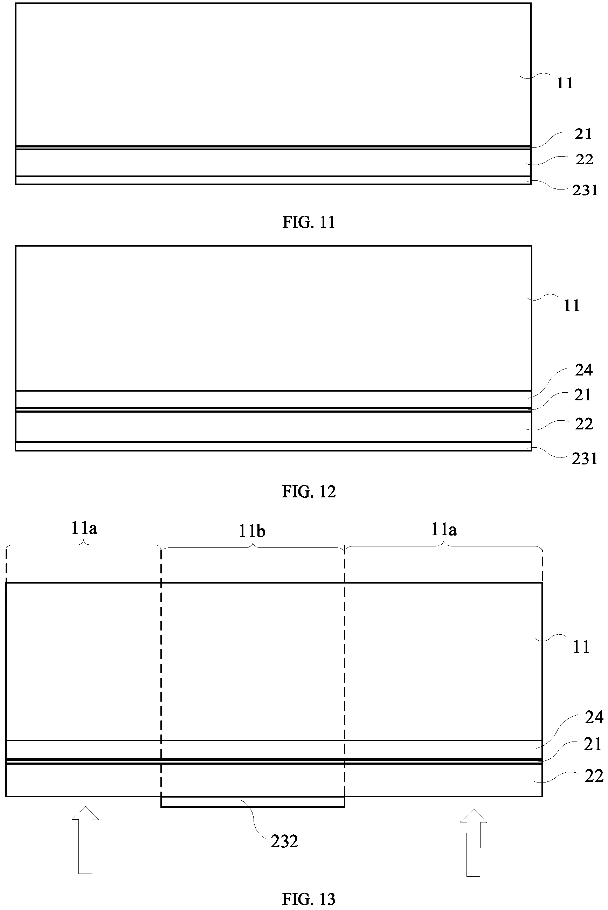

S21: forming a tunnel material layer 21 and an electrically conductive passivation material layer 22 stacked on the second surface 112. In some embodiments, the material of the tunnel material layer 21 can be a dielectric material, such as silicon oxide, aluminum oxide, silicon nitride, silicon oxynitride, magnesium fluoride, amorphous silicon, polysilicon, silicon carbide, and/or titanium oxide. The material of the electrically conductive passivation material layer 22 can be amorphous silicon, polysilicon, microcrystalline silicon, and/or silicon carbide. It can be understood that the tunnel material layer 21 and the electrically conductive passivation material layer 22 can be prepared by using a method such as ALD, plasma enhanced chemical vapor deposition (PECVD), plasma enhanced atomic layer deposition (PEALD), or low pressure chemical vapor deposition (LPCVD). The structure formed after the processes of forming the tunnel material layer 21 and the electrically conductive passivation material layer 22 can be referred to FIG. 11.

S23: forming a patterned mask layer 232 on the electrically conductive passivation material layer 22. The structure formed after the process of forming the patterned mask layer 232 can be referred to FIG. 13. The second surface 112 in the passivation regions 11a is exposed through the patterned mask layer 232, while the second surface 112 in the passivated contact regions 11b is shaded by the patterned mask layer 232. The material of the patterned mask layer 232 can be silicon oxide. Specifically, the patterned mask layer 232 can be formed by laser etching or wet etching an oxide layer 231 formed on the surface of the electrically conductive passivation material layer 22. The oxide layer 231 can be simultaneously formed during step S21.

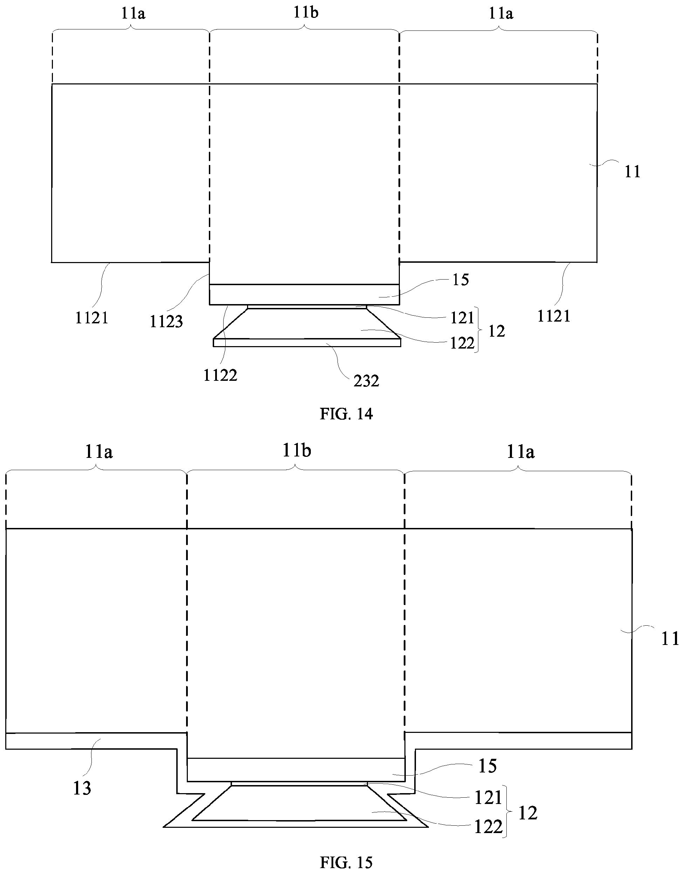

S24: removing the tunnel material layer 21 and the electrically conductive passivation material layer 22 on the passivation regions 11a, thereby forming the passivating contact structures 12. The structure formed after the process of forming the passivation contact structures 12 can be referred to FIG. 14. In some embodiments, the above layers can be removed through a wet etching process using the patterned mask layer 232.

In some embodiments, after removing the tunnel material layer 21 and the electrically conductive passivation material layer 22 on the passivation regions 11a, the exposed second surface 112 of the semiconductor substrate 11 located in the passivation regions 11a can be polished using an alkaline solution, making the depth of the second surface 112 in the passivation regions 11a greater than the depth of the second surface 112 in the passivated contact regions 11b. Through the polishing process, the sizes of most or even all of the recesses 16 in the passivation regions 11a can be enlarged, and the depths of the recesses 16 in the passivation regions 11a can be reduced, thereby reducing the roughness of the second surface 112 in the passivation regions 11a.

In some embodiments, referring to FIG. 7, after S21 of forming the tunnel material layer 21 and the electrically conductive passivation material layer 22 stacked on the second surface 112, and before S23 of forming the patterned mask layer 232 on the electrically conductive passivation material layer 22, the method further includes step S22.

S22: performing heat treatment on the electrically conductive passivation material layer 22 thereby forming an initial diffusion layer 24. Referring to FIG. 12, after the heat treatment, the initial diffusion layer 24 is formed within the semiconductor substrate 11.

It should be noted that the electrically conductive passivation material layer 22 formed in step S21 can include a doping element or not include any doping elements. When the electrically conductive passivation material layer 22 includes the doping element, the heat treatment in step S22 can activate the doping element and further crystallize the electrically conductive passivation material layer 22. Furthermore, referring to FIG. 11, when the electrically conductive passivation material layer 22 formed in step S21 includes the doping element, the oxide layer 231 can be simultaneously formed on the surface of the electrically conductive passivation material layer 22 in step S21.

When the electrically conductive passivation material layer 22 does not include any doping elements, during the heat treatment in step S22, a doping source can be introduced to allow the doping element to diffuse into the electrically conductive passivation material layer 22. The heat treatment further crystallizes the electrically conductive passivation material layer 22.

In some embodiments, referring to FIG. 7, after S24 of removing the tunnel material layer 21 and the electrically conductive passivation material layer 22 on the passivation regions 11a, the method further includes step S25.

S25: removing the initial diffusion layer 24 on the passivation regions 11a thereby forming a plurality of first diffusion layers 15. Specifically, the semiconductor substrate 11 can be polished using an alkaline solution to remove the initial diffusion layers 24 located in the passivation regions 11a. In some other embodiments, the initial diffusion layers 24 located in the passivation regions 11a are not removed and retained in the solar cell 1.

In alternative embodiments, referring to FIG. 8, S20 of forming the plurality of passivating contact structures 12 on the second surface 112 specifically includes S201 to S205.

S201: forming a tunnel material layer 21 and an electrically conductive passivation material layer 22 stacked on the second surface 112. In some embodiments, the material of the tunnel material layer 21 can be a dielectric material, such as silicon oxide, aluminum oxide, silicon nitride, silicon oxynitride, magnesium fluoride, amorphous silicon, polysilicon, silicon carbide, and/or titanium oxide. The electrically conductive passivation material layer 22 can be an amorphous silicon layer. It can be understood that the tunnel material layer 21 and the electrically conductive passivation material layer 22 can be prepared by using a method such as ALD, PECVD, PEALD, or LPCVD. Referring to FIG. 11, an oxide layer 231 can be simultaneously formed on the surface of the electrically conductive passivation material layer 22 during step S201.

S202: forming a patterned mask layer 232 on the electrically conductive passivation material layer 22. The structure formed after the process of forming the patterned mask layer 232 can be referred to FIG. 13. Specifically, the patterned mask layer 232 can be formed by laser etching or wet etching the oxide layer 231 formed on the surface of the electrically conductive passivation material layer 22.

S203: performing heat treatment on the electrically conductive passivation material layer 22 thereby forming an initial diffusion layer 24. In this step, a thin oxide film can be formed on the surface of the electrically conductive passivation material layer 22 in the passivation regions 11a.

It should be noted that the electrically conductive passivation material layer 22 formed in step S201 can include a doping element or not include any doping elements. When the electrically conductive passivation material layer 22 includes the doping element, the heat treatment in step S203 can activate the doping element and further crystallize the electrically conductive passivation material layer 22. When the electrically conductive passivation material layer 22 does not include any doping elements, during the heat treatment in step S203, a doping source can be introduced to allow the doping element to diffuse into the electrically conductive passivation material layer 22. The heat treatment further crystallizes the electrically conductive passivation material layer 22.

S204: removing the tunnel material layer 21 and the electrically conductive passivation material layer 22 on the passivation regions 11a, thereby forming the passivating contact structures 12. The structure formed after the process of forming the passivation contact structures 12 can be referred to FIG. 14. In some embodiments, the above layers can be removed through a wet etching process using the patterned mask layer 232. It should be noted that due to the presence of the thin oxide film on the surface of the electrically conductive passivation material layer 22 in the passivation regions 11a, this oxide film is conducive to controlling the rate of wet etching, thereby improving the precision of the wet etching.

S205: removing the initial diffusion layer 24 on the passivation regions 11a thereby forming a plurality of first diffusion layers 15. Specifically, the semiconductor substrate 11 can be polished using an alkaline solution to remove the initial diffusion layers 24 located in the passivation regions 11a. In some other embodiments, the initial diffusion layers 24 located in the passivation regions 11a are not removed and retained in the solar cell 1.

In a third aspect, an embodiment of the present application provides a photovoltaic module, including the solar cell described in the first aspect.

In some embodiments, the photovoltaic module includes a plurality of solar cells 1, which can be connected in series through a welding strip, so as to collect the electric energy generated by separate solar cells 1 for subsequent transmission. The solar cells 1 can be arranged at intervals, or can be stacked together in an imbricated form.

In some embodiments, the photovoltaic module further includes an encapsulation layer and a cover plate. The encapsulation layer is configured to cover the surface of a group of cells. The cover plate is configured to cover the surface of the encapsulation layer away from the cells. The solar cells 1 are electrically connected into a whole piece or multiple pieces, to form a plurality of cell groups. The plurality of cell groups are electrically connected in series and/or in parallel. Specifically, in some embodiments, the plurality of cell groups can be electrically connected through conductive strips. The encapsulation layer covers the surface of the solar cells. In some embodiments, the encapsulation layer can be an organic encapsulation film, such as an ethylene-vinyl acetate copolymer film, a polyethylene-octene elastomer film, or a polyethylene terephthalate film. The cover plate can be, for example, a glass cover plate, a plastic cover plate, or the like with a light-transmitting function.

It should be understood that, at least some of the steps shown in the drawings can include multiple sub-steps or multiple stages, these sub-steps or stages are not necessarily performed at the same time, but may be performed at different times. These sub-steps or stages are not necessarily to be sequentially performed, but can be performed alternately or in turn with at least some of the sub-steps or stages of other steps.

The technical features of the above-mentioned embodiments can be combined arbitrarily. In order to make the description concise, not all possible combinations of the technical features are described in the embodiments. However, as long as there is no contradiction in the combination of these technical features, the combinations should be considered as in the scope of the present disclosure.

The above-described embodiments are only several implementations of the present disclosure, and the descriptions are relatively specific and detailed, but they should not be construed as limiting the scope of the present disclosure. It should be understood by those of ordinary skill in the art that various modifications and improvements can be made without departing from the concept of the present disclosure, and all fall within the protection scope of the present disclosure. Therefore, the patent protection of the present disclosure shall be defined by the appended claims.

**Claims**

1. A solar cell comprising:

   a semiconductor substrate (11) including a first surface (111) and a second surface (112) that are opposite to each other, the semiconductor substrate including a plurality of passivation regions (11a) and a plurality of passivated contact regions (11b), the plurality of passivation regions and the plurality of passivated contact regions being alternately arranged along a first direction, the first direction being perpendicular to a thickness direction of the semiconductor substrate;
   a plurality of passivating contact structures (12) disposed on the second surface and correspondingly distributed on the plurality of passivated contact regions, each passivating contact structure including an electrically conductive passivation layer (122);
   a dielectric layer (13) at least covering the second surface located in the passivation regions; and

a plurality of first electrodes (14) disposed on the passivating contact structures and located at a side of the passivating contact structures away from the semiconductor substrate, each passivating contact structure being provided with at least one first electrode.

2. The solar cell according to claim 1, wherein a first distance is defined as a distance between the second surface and the first surface in the passivation regions, and a second distance is defined as a distance between the second surface and the first surface in the passivated contact regions; and the second distance is greater than the first distance;

preferably, a difference between the second distance and the first distance is greater than 1 $\mu$m.

3. The solar cell according to claim 2, wherein further comprising a plurality of first diffusion layers (15) located within the semiconductor substrate, wherein the first diffusion layers are correspondingly distributed in the passivated contact regions, and each first diffusion layer is in contact with the second surface;

preferably, a difference between the second distance and the first distance is greater than or equal to a size of each first diffusion layer in the thickness direction of the semiconductor substrate.

4. The solar cell according to any one of claims 1 to 3, wherein the second surface is a back surface.

5. The solar cell according to any one of claims 1 to 4, wherein a roughness of the second surface in the passivation regions is less than a roughness of the second surface in the passivated contact regions.

6. The solar cell according to any one of claims 1 to 5, wherein a plurality of recesses (16) are defined in the second surface, the plurality of recesses including a first recess (16a) and a second recess (16b), the first recess is a deepest recess in the passivation regions, and the second recess is a deepest recess in the passivated contact regions; the first recess is shallower than the second recess;

preferably, an inner size of the first recess is greater than an inner size of the second recess.

7. The solar cell according to any one of claims 1 to 6, wherein along a direction from the second surface to the first surface, a dimension of the passivating contact structures in the first direction gradually decreases.

8. The solar cell according to claim 7, wherein the each passivating contact structure further includes a tunnel layer (121) disposed between the electrically conductive passivation layer and the semiconductor substrate;

wherein along the direction from the second surface to the first surface, a dimension of the electrically conductive passivation layer in the first direction gradually decreases; preferably, the each passivating contact structure is provided with one first electrode; the electrically conductive passivation layer includes a first face adjacent to the tunnel layer and a second face away from the tunnel layer;
a dimension of the first face along the first direction, a dimension of the second face along the first direction, and a dimension of the first electrode along the first direction satisfy the following relationship:

$$W_2 > W_1 > W_3$$

wherein $W_1$ is the dimension of the first face in the first direction, $W_2$ is the dimension of the second face in the first direction, and $W_3$ is the dimension of the first electrode in the first direction.

9. The solar cell according to any one of claims 1 to 8, wherein the dielectric layer further covers surfaces of the passivated contact structures away from the semiconductor substrate; and/or

the dielectric layer further covers surfaces of the passivating contact structures adjacent to the passivation regions;
preferably, the second surface of the semiconductor substrate includes first sub-surfaces (1121), second sub-surfaces (1122), and connecting surfaces (1123); the first sub-surfaces are located in the passivation regions, the second sub-surfaces are located in the passivated contact regions, and the first sub-surfaces and the second sub-surfaces are connected by the connecting surfaces adjacent thereto; and the dielectric layer further covers the connecting surfaces;
further preferably, each second sub-surface includes a sub-contact surface (11221) and two non-contact surfaces (11222), and the two non-contact surfaces are located at opposite sides of the sub-contact surface in the first direction; the passivating contact structure is in contact with the sub-contact surface; and the dielectric layer further covers the two non-contact surfaces.

10. The solar cell according to any one of claims 1 to 9, wherein a material of the dielectric layer includes one or more of aluminum oxide, silicon nitride, or silicon oxynitride.

11. The solar cell according to any one of claims 1 to 10, wherein the electrically conductive passivation layer includes a doped polysilicon layer doped with an n-type doping element or a p-type doping element;

preferably, the doped polysilicon layer is further doped with one or more of carbon, nitrogen, or oxygen; and/or preferably, the electrically conductive passivation layer further includes a silicon carbide layer disposed at a side of the doped polysilicon layer away from the semiconductor substrate.

12. A method for preparing a solar cell, comprising:

providing a semiconductor substrate, the semiconductor substrate including a first surface and a second surface that are opposite to each other, the semiconductor substrate including a plurality of passivation regions and a plurality of passivated contact regions, the plurality of passivation regions and the plurality of passivated contact regions being alternately arranged along a first direction, the first direction being perpendicular to a thickness direction of the semiconductor substrate;
forming a plurality of passivating contact structures on the second surface and correspondingly on the plurality of passivated contact regions, each passivating contact structure including an electrically conductive passivation layer;
forming a dielectric layer on the semiconductor substrate, the dielectric layer at least covering the second surface located in the passivation regions; and
forming a plurality of first electrodes on the plurality of passivating contact structures, at least one first electrode being formed at a side of each passivating contact structure away from the semiconductor substrate.

13. The method according to claim 12, wherein forming the plurality of passivating contact structures includes:

forming a tunnel material layer (21) and an electrically conductive passivation material layer (22) that are stacked on the second surface;
forming a patterned mask layer (232) on the electrically conductive passivation material layer; and
removing the tunnel material layer and the electrically conductive passivation material layer on the passivation regions, thereby forming the plurality of passivating contact structures.

14. The method according to claim 13, wherein after forming the tunnel material layer and the electrically conductive passivation material layer stacked on the second surface, and prior to forming the patterned mask layer on the electrically conductive passivation material layer, the method further comprises performing heat treatment on the electrically conductive passivation material layer thereby forming an initial diffusion layer (24); or

after forming the patterned mask layer on the electrically conductive passivation material layer, and prior to removing the tunnel material layer and the conductive passivation material layer on the passivation regions thereby forming the passivating contact structures, the method further comprises performing heat treatment on the electrically conductive passivation material layer thereby forming an initial diffusion layer; and
after removing the tunnel material layer and the conductive passivation material layer on the passivation regions thereby forming the passivating contact structures, the method further comprises removing the initial diffusion layer on the passivation regions thereby forming a plurality of first diffusion layers.

15. A photovoltaic module comprising the solar cell according to any one of claims 1 to 11.

1

11a        11b        11a

111

11

112

13

W₁

15

X

121
122  12

14

W₃

W₂

FIG. 1

11a        11b        11a

111

11

A        16        16        16

16        B

FIG. 2

$H_1$

16a

$D_1$

FIG. 3

$H_2$

16b

16

$D_2$

FIG. 4

11a

11b

11a

111

11

1121

1123

1121

11222

11221

11222

1123

1122

FIG. 5

| providing a semiconductor substrate | S10 |

↓

| forming a plurality of passivating contact structures on the second surface | S20 |

↓

| forming a dielectric layer on the semiconductor substrate | S30 |

↓

| forming a plurality of first electrodes on the passivating contact structures | S40 |

FIG. 6

| forming a tunnel material layer and an electrically conductive passivation material layer stacked on the second surface | S21 |

↓

| performing heat treatment on the electrically conductive passivation material layer thereby forming an initial diffusion layer | S22 |

↓

| forming a patterned mask layer on the electrically conductive passivation material layer | S23 |

↓

| removing the tunnel material layer and the electrically conductive passivation material layer on the passivation regions, thereby forming the passivating contact structures | S24 |

↓

| removing the initial diffusion layer on the passivation regions thereby forming a plurality of first diffusion layers | S25 |

FIG. 7

forming a tunnel material layer and an electrically conductive passivation material layer stacked on the second surface ⟩ S201

forming a patterned mask layer on the electrically conductive passivation material layer ⟩ S202

performing heat treatment on the electrically conductive passivation material layer thereby forming an initial diffusion layer ⟩ S203

removing the tunnel material layer and the electrically conductive passivation material layer ⟩ S204

removing the initial diffusion layer on the passivation regions thereby forming a plurality of first diffusion layers ⟩ S205

FIG. 8

11

FIG. 9

11

16    16    16    16

FIG. 10

FIG. 11

FIG. 12

FIG. 13

FIG. 14

FIG. 15